# EUROPEAN PATENT APPLICATION

(11) **EP 4 386 822 A1**
(43) Date of publication of application: **19.06.2024**
(21) Application number: 22918427.0
(22) Date of filing: 23.12.2022
(51) Int. Cl.: H01L 21/67, H01L 21/677

(54) **WAFER PROCESSING DEVICE, WAFER PROCESSING SYSTEM AND CONTROL METHOD**

(30) Priority: 04.01.2022 CN 202210003273
(71) Applicant: Jiangsu Leadmicro Nano-Technology Co., Ltd., Wuxi, Jiangsu 214112 (CN)
(72) Inventor: ZHOU, Ren, Fremont, California 94539 (US); YANG, Dezan, Wuxi, Jiangsu 214112 (CN); WANG, Zhuo, Wuxi, Jiangsu 214112 (CN); XIE, Tian, Wuxi, Jiangsu 214112 (CN); ZHU, Xiaoli, Wuxi, Jiangsu 214112 (CN)
(74) Representative: Bayramoglu et al.
(86) International application number: PCT/CN2022/141351
(87) International publication number: WO 2023/130984

(57) **Abstract**

The present disclosure provides a wafer processing device, a wafer processing system and a control method. The wafer processing device includes a driving unit, a transfer chamber, a plurality of process chambers and a bearing assembly; the bearing assembly is arranged in the transfer chamber, the process chamber is coupled to the transfer chamber, the process chamber is used for processing wafers, the bearing assembly is used for supporting the wafer, the driving unit is used for adjusting a position of the bearing assembly in the transfer chamber, and the driving unit is further used for driving the bearing assembly to move between the transfer chamber and the process chambers. The wafer processing device of the present disclosure can directly transport the wafers to be processed to the process chambers by the driving unit for the processing treatment, and can retain or transfer the wafers to be transferred or not to be directly processed in the transfer chamber, thus reducing the time of wafers occupying the working station due to different groups of wafers waiting for process, which will speed up the processing efficiency of the wafers and provide basic conditions for synchronously processing groups of wafers by the transfer chamber and the bearing assembly.

## Description

### TECHNICAL FIELD

The present disclosure relates to the technical field of semiconductor processing, in particular to a wafer processing device, a wafer processing system and a control method.

### BACKGROUND

Wafer processing is used to process semiconductors by techniques comprising: Physical Vapor Deposition (PVD), Chemical vapor deposition (CVD), Plasma enhanced chemical vapor deposition (PECVD), Atomic layer deposition (ALD), Plasma enhanced atomic layer deposition (PEALD), Pulse deposition layer (PDL), Molecular layer deposition (MLD), plasma enhanced pulses Plasma enhanced pulsed deposition layer (PEPDL) treatment, etching and resist removal.

Wafer processing needs to be pre-heated firstly. In the existing wafer processing device, a heating plate is usually arranged on the processing chamber when pre-heating the wafers. Before the process in the processing chamber, the wafer is pre-heated by the heating plate, and then the wafer processing is then carried out after reaching predetermined conditions on the heating plate.

Such a processing method for wafer processing causes the problems of long occupation time and low efficiency when processing the wafers.

### SUMMARY

The purpose of the present disclosure is to provide a wafer processing device, a wafer processing system and a control method. The wafer processing device can directly transport the wafer to be processed to the process chamber by the driving unit for the processing process, and can retain or transfer the wafers to be transferred or not to be directly processed in the transfer chamber, thereby reducing the time of wafers occupying the working station due to different groups of wafers waiting for process, which will speed up the processing efficiency of the wafers, simultaneously provide basic conditions for synchronously processing a plurality of wafers or a plurality of groups of wafers by the transfer chamber and the bearing assembly, and solve the problems of long time occupation and low efficiency in the prior art.

To achieve the above purpose, the present disclosure provides a wafer processing device, the wafer processing device comprises wafer processing device comprising a driving unit, a transfer chamber, a plurality of process chambers, a first air extraction device, a second air extraction device, and a bearing assembly; and the process chambers coupled to the transfer chamber; wherein the transfer chamber is configured to provide a sealed space, the first air extraction device is coupled to the transfer chamber, and the first air extraction device is configured to extract gas in the transfer chamber to carry out a first vacuum treatment on the transfer chamber; wherein the process chambers are configured for processing a wafer, the second air extraction device or devices are coupled to the respective process chambers, and the second air extraction device is configured to extract gas in the process chamber to carry out a second vacuum treatment on the process chamber; the bearing assembly is arranged in the transfer chamber, the bearing assembly is configured for supporting the wafers; and the driving unit is configured to adjust a position of the bearing assembly in the transfer chamber and further to drive the bearing assembly to move between the transfer chamber and the process chambers.

The wafer processing device of the present disclosure has the beneficial effect that the process chambers are provided so that the wafers, placed in the process chambers, will be processed. The process or treatment here includes heating, deposition, coating, etching or other processes or treatments. The wafers are supported by providing a bearing assembly or assemblies. By providing the transfer chamber with a sealing space performed by the first vacuum treatment on the transfer chamber, wafers can. And the process chambers can provide another sealing space with the second vacuum treatment, such that groups of wafers in the transfer chamber can be retained or transferred in the transfer chamber with a first vacuum condition, and can be controlled flexibly by the driving unit and freely shifted between the transfer chamber with a first vacuum condition and the process chambers with a second vacuum condition, thereby avoiding the wafers' quality damage caused by the transfer in a non-vacuum environment before the wafers enter the process chambers in the prior art. According to the present disclosure, the delivery or transport of different groups of wafers to the mini processing chamber or chambers for the processing process can be flexibly controlled due to having a transfer chamber with a first vacuum condition for the wafer transfer, allowing wafers to be shifted freely between the transfer chamber with a first vacuum condition and the mini processing chamber or chambers with a second vacuum condition and thereby ensuring that the wafers are not damaged, and this provides base conditions for different processing processes at the same time of wafers or groups of wafers. The driving unit drives the bearing assembly to move between the transfer chamber and the process chamber or chambers, or adjusts the position of the bearing assembly in the transfer chamber. Thus, the wafer processing device of the present application can flexibly control the transfer of wafers in the transfer chamber, or flexibly control the wafers to be transported to the process chambers for the processing process by the driving unit, the transfer chamber and the process chambers, and at the same time, wafers can be placed on one bearing assembly for the processing or circulation process according to needs, thus reducing the time for the wafer or wafers to occupy the process chambers and improving the processing efficiency of the processing device. In addition, the transport time between different groups of wafers or the interval time for different processing processed can be reduced by the flexible application of the driving unit, thus further improving the processing efficiency of the processing device.

In a feasible embodiment, the process chamber are defined to have a first pre-heating chamber for pre-heating or heating the wafers and a first mini processing chamber for processing the wafers. The wafer processing device of the present disclosure has the beneficial effect that by the process chambers defined to have the first pre-heating chamber and the first mini processing chamber, different groups of wafers can be synchronously heated and processed at different chambers, and the heating process or treatment can be pre-heating treatment or post-heating treatment so as to solve the problems of long time occupation and low efficiency in pre-heating or heating treatment of wafers in the prior art. At the same time, since the transfer chamber provides the first vacuum condition, different groups of wafers can be retained or transferred in the transfer chamber under the first vacuum condition before entering the first pre-heating chamber or the first mini processing chamber, thus avoiding the wafers' quality damage caused by transfer under the non-vacuum environment of the transfer chamber before entering the process chambers in the prior art. According to the present disclosure, different groups of wafers to be transported to the pre-heating chamber or the process chamber for treatment can be flexibly or freely controlled by providing the transfer chamber with the first vacuum condition for temporary storage or transfer of the wafers, thus reducing waiting time for treatment of different groups of wafers and speeding up the processing efficiency of different groups of wafers.

In a feasible embodiment, the process chambers are defined to have a first pre-heating chamber, a second pre-heating chamber, a first mini processing chamber and a second mini processing chamber, wherein the first pre-heating chamber and the second pre-heating chamber are configured to pre-heat or heat a first group of wafers and a second group of wafers respectively, and the first mini processing chamber and the second mini processing chamber are configured to process the first group of wafers and the second group of wafers respectively. The wafer processing device of the present disclosure has the beneficial effect that by providing two mini processing chambers and two pre-heating chambers, the same group of wafers can be sequentially heated and processed, and the different groups of wafers can synchronously heated and processed at the same time so as to solve the problems of long time occupation and low efficiency in pre-heating or heating wafers in the prior art, and greatly improve the process efficiency of groups of wafers. At the same time, since the transfer chamber provides the first vacuum condition, the first group of wafers and the second group of wafers can be retained or transferred in the transfer chamber with the first vacuum condition before entering into the first pre-heating chamber and the second pre-heating chamber respectively and then into the first mini processing chamber and the second mini processing chamber respectively, so as to avoid the wafers' quality damage caused by the prior art that the wafer was transferred under the non-vacuum environment before entering the process chambers. According to the present disclosure, different groups of wafers to be transported to the first pre-heating chamber, the second pre-heating chamber, the first mini processing chamber and the second mini processing chamber for treatment can be flexibly controlled by providing the transfer chamber with the first vacuum condition for temporary storage or transfer of the wafers, thus reducing waiting time for pre-heating or heating treatment of different groups of wafers and speeding up the processing efficiency of different groups of wafers.

In a feasible embodiment, the process chambers are provided on an upper side or a lower side of the transfer chamber, and the driving unit is provided on a side of the transfer chamber away from the process chambers. The wafer processing device of the present disclosure has the beneficial effect that the process chambers are arranged on the upper side or the lower side of the transfer chamber, which facilitates the installation of the bearing assembly and the support for the wafers, and the driving unit is arranged on the side of the transfer chamber away from the process chamber, which facilitates the driving unit to drive the bearing assembly and the transport of the wafers.

In a feasible embodiment, the driving unit includes a first driving mechanism, a second driving mechanism and a transfer; and the transfer is arranged in the transfer chamber, the first driving mechanism is coupled to the transfer, and the first driving mechanism is configured for driving the transfer to move or rotate at an angle; and wherein the bearing assembly is arranged on the transfer, the second driving mechanism is arranged on a side of the transfer, and the second driving mechanism is configured for driving the bearing assembly to move between the process chamber and the transfer chamber. The wafer processing device of the present disclosure has the beneficial effect that the first driving mechanism drives the transfer to move in the transfer chamber. Due to the bearing assembly is arranged on the transfer, the position of the bearing assembly can be adjusted. The second driving mechanism can drive the bearing assembly to move to the process chambers so as to process the wafers.

In a feasible embodiment, the transfer and the first driving mechanism are detachably coupled thereto. The wafer processing device of the present disclosure has the beneficial effect that the utility model is convenient for maintenance or replacement of the transfer.

In a feasible embodiment, the driving unit further comprises a couple mechanism; and the couple mechanism is arranged on the bearing assembly or the transfer, the couple mechanism is provided with a first clamping part, the bearing assembly or the transfer is provided with a second clamping part fitting with the first clamping part, and the couple mechanism is used to couple the transfer to a couple part of the couple mechanism. The wafer processing device of the present disclosure has the beneficial effect that the bearing assembly and the transfer can be coupled together by the first clamping part and the second clamping part of the couple mechanism, and when the second driving mechanism is to drive the bearing assembly to move, the bearing assembly can be moveable along with the transfer and the bearing assemblies of the transfer.

In a feasible embodiment, the driving unit further includes a third driving mechanism; and the third driving mechanism is arranged on a side of the transfer, and the third driving mechanism is configured to drive the transfer and the bearing assembly to move. The wafer processing device of the present disclosure has the beneficial effect that the transfer can be driven by the third driving mechanism, and the bearing assemblies can be driven to move as the transfer is driven, and when a plurality of bearing assemblies are provided, each of the bearing assemblies can be synchronously driven to move.

In a feasible embodiment, at least two bearing assemblies are provided. The wafer processing device of the present disclosure has the beneficial effect that the wafers can be supported by the two bearing assemblies, thereby facilitating the asynchronous process.

In a feasible embodiment, at least two second driving mechanisms are provided, each of the at least two second driving mechanisms is used to drive the bearing assemblies respectively. The wafer processing device of the present disclosure has the beneficial effect that at least two second driving mechanisms are provided, and the two second driving mechanisms are respectively arranged corresponding to different bearing assemblies so as to drive different bearing assemblies to carry out synchronous or asynchronous movements, and the flexibility is improved.

In a feasible embodiment, the bearing assembly is provided with N support portions, each of the support portions is configured to support the wafers, and N is an integer greater than 1. The wafer processing device of the present disclosure has the beneficial effect that by arranging N support portions on the bearing assembly, wafers can be arranged at the same time on one bearing assembly, and wafers can be processed at the same time, thereby improving the processing efficiency.

In a feasible embodiment, a plurality of process chambers is provided, each of the plurality of process chambers operates or works independently, and the driving unit is configured to drive the bearing assembly to move between the process chambers and the transfer chamber. The wafer processing device of the present disclosure has the beneficial effect that by providing separate mini processing chambers, different groups of wafers can be synchronously heated and processed, and the same group of wafers can be sequentially heated and processed.

In a feasible embodiment, two process chambers are provided, and the two process chambers are set to be two mini processing chambers, or the two process chambers are set to two pre-heating chambers, or the two process chambers are set to be one process chamber and one pre-heating chamber. The wafer processing device of the present disclosure has the beneficial effect that by arranging two mini processing chambers, different or different groups of wafers can be processed synchronously, and the same wafer or the same group of wafers can be sequentially processed in two steps at different times.

In a feasible embodiment, the wafer processing device includes a feeding mechanism; and the feeding mechanism is coupled to the process chamber, and the feeding mechanism is configured for providing raw materials to process the wafer or wafers by the process chamber. The wafer processing device of the present disclosure has the beneficial effect that the feeding mechanism can provide raw materials when the process chambers need to process the wafers, thus ensuring the normal operation of the device.

In a feasible embodiment, the wafer processing device further includes a seal provided on the bearing assembly, the seal being configured to separate the transfer chamber from the process chamber. The wafer processing device of the present disclosure has the beneficial effect that the process chamber and the transfer chamber can be separated by the seal, thus avoiding the diffusion of raw materials or temperature into the transfer chamber when the treatment is carried out in the process chambers, and ensuring the normal treatment.

In a feasible embodiment, the wafer processing device further includes a fourth driving mechanism; the fourth driving mechanism is arranged on a side of the bearing assembly, and the fourth driving mechanism is configured for driving the bearing assembly to rotate at an angle. The wafer processing device of the present disclosure has the beneficial effect that the fourth driving mechanism can drive the bearing assembly to rotate at an angle, an angle of the wafer on the bearing assembly can be adjustable, and the quality of the wafers after processed can be guaranteed.

In a feasible embodiment, the wafer processing device further includes an equipment body; and the equipment body is provided with the process chamber and the transfer chamber, the driving unit is arranged on the equipment body, and a sealing mode between the driving unit and the equipment body is adopted with a dynamic seal. The wafer processing device of the present disclosure has the beneficial effect that the partial structure of the driving unit can be arranged on the outer side of the transfer chamber, thus the space of the transfer chamber does not need to be larger, the difficulty of manufacture during the treatment can be reduced.

In a feasible embodiment, the wafer processing device further includes a fifth driving mechanism; wherein the equipment body comprises a first fixing part and a second fixing part; the mini processing chamber and the pre-heating chamber are arranged on the first fixing part, and the first fixing part and the second fixing part are stacked with each other to form the transfer chamber within the first fixing part and the second fixing part; and wherein the fifth driving mechanism is arranged on the first fixing part and/or the second fixing part, and the fifth driving mechanism is configured to drive the first fixing part or the second fixing part to move. The wafer processing device of the present disclosure has the beneficial effect that the space of the transfer chamber can be opened and closed by enabling the equipment body to have the first fixing part and the second fixing part stacked with each other. By arranging the fifth driving mechanism, the first fixing part and/or the second fixing part can be driven to move by the fifth driving mechanism, and it is convenient for opening and closing the transfer chamber and for cleaning or maintenance.

In a feasible embodiment, the wafer processing device further includes a heating unit; and the heating unit is coupled to the transfer chamber, and the heating unit is configured for heating the transfer chamber. The wafer processing device of the present disclosure has the beneficial effect that the transfer chamber can be heated by the heating unit, the wafers or devices located in the transfer chamber can be heated, and the temperature of the wafers can be guaranteed or the wafers can be pre-heated.

The present disclosure also provides a wafer processing system, the wafer processing system comprising a transport device and the wafer processing device described in any feasible embodiment; and the wafer processing device is provided with a transport channel, the transport device is coupled to the transport channel, and the transport device is configured for transporting the wafers. The wafer processing system of the present disclosure has the beneficial effect that the transport device is convenient for transporting the wafers to the wafer processing device and also convenient for removal of the wafers from the wafer processing device.

In a feasible embodiment, at least two wafer processing devices are provided, and the two wafer processing devices are provided on different sides of the transport device, the transport device is configured for transporting the wafers to the respective wafer processing devices, and the transport device is configured for transporting the wafers of the respective wafer processing devices. The wafer processing system of the present disclosure has the beneficial effect that at least two wafer processing devices are coupled to one transport device so that the one transport devices is applied with the two wafer processing devices, and this can improve the utilization rate of the transport device, save the occupied space and reduce the system cost.

In a feasible embodiment, the wafer processing system also includes a front processing device; and the front processing device is arranged at a side of the transport device, the front processing device is provided with a wafer circulating box, the transport device is configured to transport the wafers to the wafer circulating box and/or the wafer processing device, and the front processing device is configured for transporting the wafer circulating box. The wafer processing device of the present disclosure has the beneficial effect that by arranging the front processing device and the wafer circulating box, the wafers outputted by the transport device can be transported within the front processing device to the wafer circulating box, thereby reducing the possibility of the wafers being polluted.

In a feasible embodiment, the wafer processing system further includes a wafer transport box and a transport mechanism; wherein the wafer transport box is arranged on the front processing device, and the front processing device is configured for conveying the wafer circulating box to the wafer transport box; and the transport mechanism is configured for conveying the wafer transport box. The wafer processing system of the present disclosure has the beneficial effect that the wafer transport box can be transported to the wafer transport box via the front-end processing module by the wafer transport box and the transport device, and the wafer transport box can be transferred by the transport device, and it is convenient for inputting and outputting wafers.

The present disclosure also provides a control method of the wafer processing device, comprising:
S 1. transmitting a wafer to a bearing assembly in a transfer chamber, wherein a first air extraction device is coupled to the transfer chamber, and the first air extraction device is configured to extract gas in the transfer chamber to carry out a first vacuum treatment on the transfer chamber;
S2. driving, by a driving unit, the bearing assembly to move to a process chamber, wherein a second air extraction device is coupled to the process chamber, and the second air extraction device is configured to extract gas in the process chamber to carry out a second vacuum treatment on the process chamber;
S3. processing the wafer on the bearing assembly by the process chamber;
S4. driving, by driving unit, the bearing assembly to transport a processed wafer to the transfer chamber; and
S5. removing the processed wafer from the transfer chamber.

In a feasible embodiment, the driving unit comprises a first driving mechanism, a second driving mechanism and a transfer;
the step S2 specifically comprises:
S21. driving, by the first driving mechanism, the bearing assembly on the transfer to move so as to adjust a position of the bearing assembly in the transfer chamber; and
S22. driving, by the second driving mechanism, the bearing assembly to move to the process chamber.

In a feasible embodiment, the process chamber is provided on an upper face or a lower face of the transfer chamber, and the driving unit is provided on a side of the transfer chamber away from the process chamber;
the step S22 specifically comprises: driving, by the second driving mechanism, the bearing assembly to move to the process chamber in an upwardly or downwardly direction.

In a feasible embodiment, at least two second driving mechanisms are provided, and each of the two second driving mechanisms works independently; and
the step S22 further comprises: driving, by the at least two second driving mechanisms, the bearing assembly to move to the process chamber in an up or down direction.

In a feasible embodiment, there are provided with a plurality of the process chambers, each of the plurality of process chambers works independently, and the process chambers comprise at least a first pre-heating chamber and a first mini processing chamber;
the step S2 and the step S3 specifically comprise:
S31. driving, by the driving unit, the bearing assembly to move to the first pre-heating chamber to pre-heat or heat the wafer on the bearing assembly; and
S32. driving, by the driving unit, the bearing assembly to move to the first mini processing chamber to process the wafers on the bearing assembly.

In a feasible embodiment, there are two pre-heating chambers and two mini processing chambers;
the step S31 specifically comprises:
   S311. driving, by the driving unit, the bearing assembly to move to a first pre-heating chamber to pre-heat or heat the wafers on the bearing assembly for a first time; and
   S312. driving, by the driving unit, the bearing assembly to move to a second pre-heating chamber to pre-heat or heat the wafers on the bearing assembly for a second time;
the step S32 specifically comprises:
   S321. driving, by the driving unit, the bearing assembly to move to a first mini processing chamber, and carrying out a first processing treatment on the wafers on the bearing assembly; and
   S322. driving, by the driving unit, the bearing assembly to move to a second mini processing chamber, and carrying out a second processing treatment on the wafers on the bearing assembly.

In a feasible embodiment, there are provided with two bearing assemblies, two pre-heating chambers and two mini processing chambers;
the step S31 specifically comprises: driving, by the driving unit, the two bearing assemblies to move to the two pre-heating chambers respectively, and pre-heating or heating a first group of wafers and a second group of wafers on the two bearing assemblies in a first pre-heating chamber and a second pre-heating chamber respectively within a first predetermined time; and
the step S32 specifically comprises: driving, by the driving unit, the two bearing assemblies to move to the two mini processing chambers respectively, and processing the first group of wafers and the second group of wafers on the two bearing assemblies in a first mini processing chamber and a second mini processing chamber respectively within a second predetermined time.

In a feasible embodiment, it also includes:
S0. providing a front processing device and a transport device; and
the step S 1 specifically comprises: storing the wafers to be processed in the front processing device, and moving the wafers to be processed to the bearing assembly of the transfer chamber by the transport device.

### BRIEF DESCRIPTION OF DRAWINGS

FIG. 1 is a stereoscopic structural schematic diagram of a wafer processing device in a first embodiment of the present disclosure;
FIG. 2 is a partial structural diagram of FIG. 1;
FIG. 3 is a structural schematic diagram of a bearing assembly in FIG. 1;
FIG. 4 is a structural schematic diagram of a pre-heating chamber in FIG. 1;
FIG. 5 is a structural diagram of a first driving mechanism in a second embodiment of the present disclosure;
FIG. 6 is a schematic structural diagram of a third driving mechanism in a second embodiment of the present disclosure;
FIG. 7 is a structural schematic diagram of a bearing assembly in a third embodiment of the present disclosure;
FIG. 8 is a schematic structural diagram of a fourth driving mechanism in a fourth embodiment of the present disclosure;
FIG. 9 is a structural schematic diagram of a transfer chamber in a fifth embodiment of the present disclosure;
FIG. 10 is a stereoscopic structural schematic diagram of a wafer processing system in the above embodiments of the present disclosure; and
FIG. 11 is a flow diagram of a control method of the wafer processing device in the above embodiments of the present disclosure.

### Reference signs in the drawings:

1. equipment body;
100. process chamber;
101. mini processing chamber; 1011. first cover;
102, pre-heating chamber; 1021. second cover;
103. transfer chamber;
104. first fixing part;
105. second fixing part;
2. bearing assembly; 201. support portion; 202. first bearing assembly;
3. second bearing assembly;
4. driving unit; 401. first driving mechanism; 402. second driving mechanism; 403. transfer; 404. third driving mechanism;
5. feeding mechanism;
6. fourth driving mechanism;
7. fifth driving mechanism;
8. heating unit;
9. first air extraction device;
10. transport device;
11. wafer processing device;
12. front processing device;
13. wafer transport box.

### DESCRIPTION OF THE EMBODIMENTS

In order to make objectives, technical solutions, and advantages of the present disclosure clearer, the technical solutions in the present disclosure are described clearly and completely in the following with reference to accompanying drawings in the embodiments of the present disclosure. Apparently, the described embodiments are only portion rather than all of the embodiments of the present disclosure. Based on the embodiments of the present disclosure, all the other embodiments obtained by those of ordinary skill in the art without inventive effort are within the scope of the present disclosure. Unless otherwise mentioned, all technical and scientific terms used herein have the same meaning as commonly understood by one of ordinary skill in the art to which the present disclosure belongs. The term "including" and the like as used herein means that the elements or articles appearing before the term encompass the enumerated elements or articles appearing after the term and their equivalents, without excluding other elements or articles.

Aiming at the problems existed in the prior art, the embodiments of the present disclosure provide a wafer processing device.

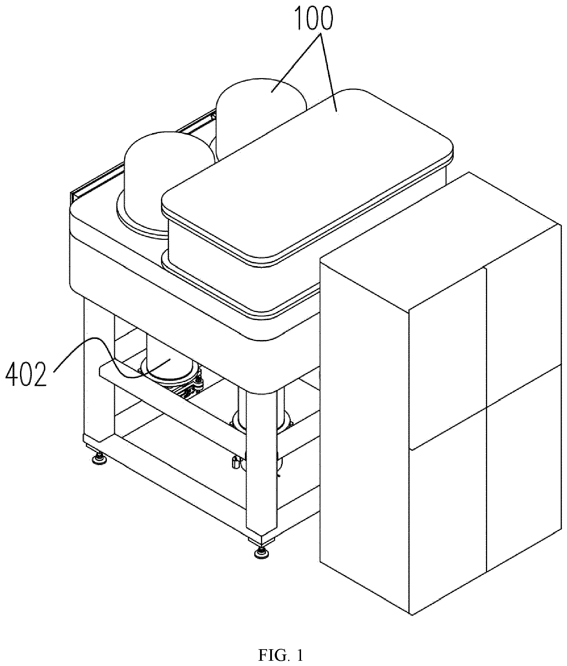

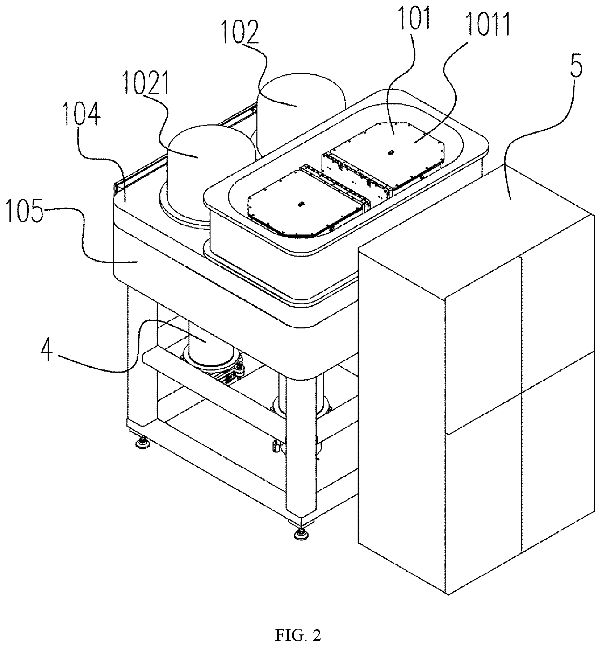

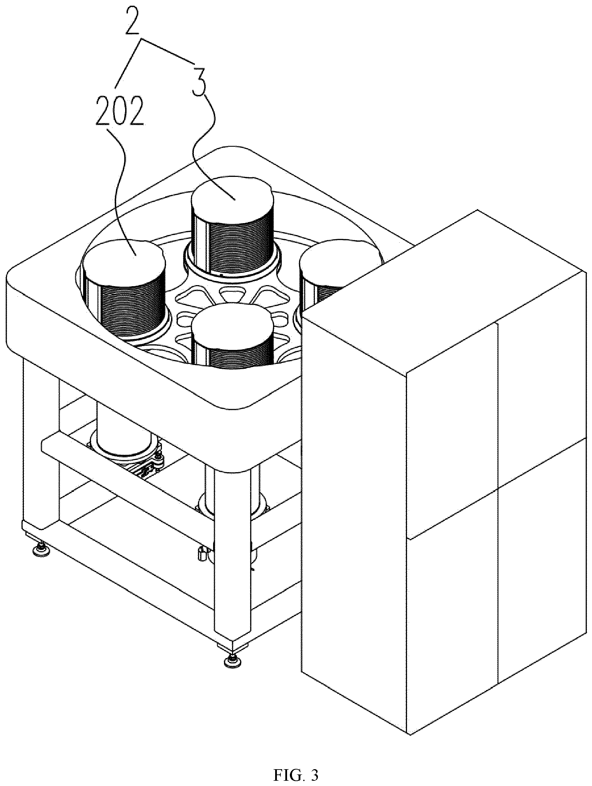

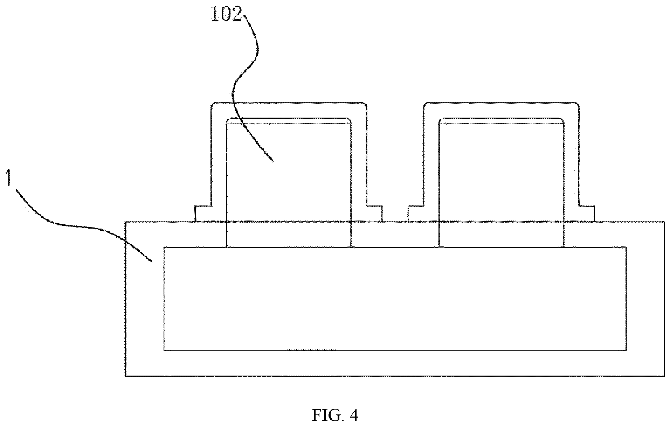

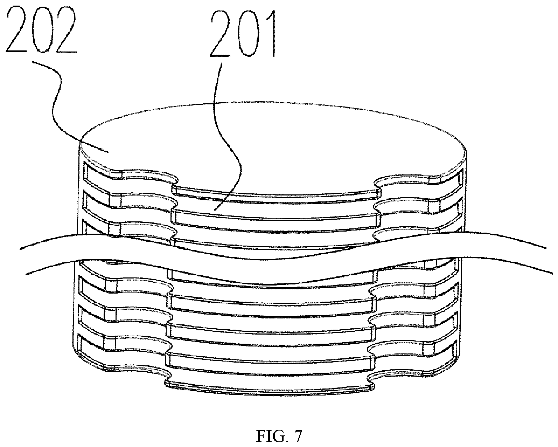

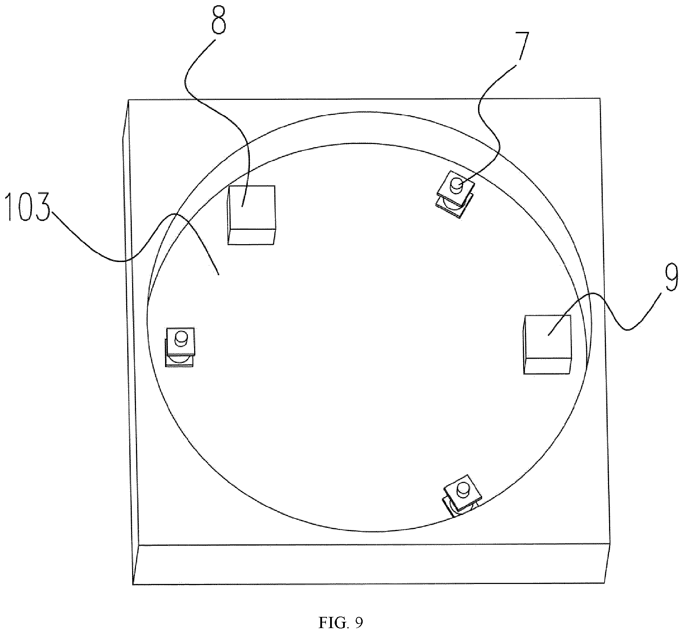

FIG. 1 is a stereoscopic structural schematic diagram of a wafer processing device in a first embodiment of the present disclosure, FIG. 2 is a partial structural diagram of FIG. 1, FIG. 3 is a structural schematic diagram of a bearing assembly in FIG. 1, FIG. 4 is a structural schematic diagram of a pre-heating chamber in FIG. 1, FIG. 7 is a structural schematic diagram of a bearing assembly in a third embodiment of the present disclosure, and FIG. 9 is a structural schematic diagram of a transfer chamber in a fifth embodiment of the present disclosure.

In some embodiments of the present disclosure, the wafer processing device 11 includes a driving unit 4, a transfer chamber 103, a plurality of process chambers 100, a first air extraction device 9, a second air extraction device (not shown), and a bearing assembly 2. The process chamber 100 is coupled to the transfer chamber 103; wherein the transfer chamber 103 is configured to provide a sealed space, the first air extraction device 9 is coupled to the transfer chamber 103, and the first air extraction device 9 is configured for extracting gas in the transfer chamber 103 to carry out a first vacuum treatment on the transfer chamber 103, so that the transfer chamber 10 is set to have the first vacuumed condition, wherein the process chambers 100 are configured for processing wafers, the second air extraction device (not shown) is coupled to the process chambers 100, and the second air extraction device (not shown) is configured for extracting gas in the process chamber 100 to carry out a second vacuum treatment on the process chamber 100, so that the process chamber 100 is set to have a second vacuum condition. The bearing assembly 2 is arranged in the transfer chamber 103, the bearing assembly 2 is configured for supporting the wafer; and the driving unit 4 is configured to adjust a position of the bearing assembly 2 in the transfer chamber 103, and further to drive the bearing assembly 2 to move between the transfer chamber 103 and the process chamber 100. Here, the transfer chamber 103 works or operates at a transport pressure, generally 0.1 to 0.3 Torr (unit of pressure intensity), and the transfer chamber 103 has a first vacuum condition corresponding to the transport pressure of the transfer chamber 103. The process chamber 100 operates at a process pressure, e.g., 1 Torr (unit of pressure intensity), and the process chamber 100 has a second vacuum condition corresponding to the process pressure of the process chamber 100, i.e., the first vacuum condition of the transfer chamber is different from the second vacuum condition of the process chamber. In other embodiments of the present disclosure, the first vacuum condition of the transfer chamber is the same as the second vacuum condition of the process chamber.

In some embodiments, a plurality of mini processing chambers 100 are provided, each of the plurality of mini processing chambers 100 operates independently, and the driving unit 4 is configured for driving the bearing assembly 2 to move between the mini processing chambers 100 and the transfer chamber 103. In some specific embodiments, the mini process chambers 100 may be provided in two, three, four or more numbers. In some embodiments of the present disclosure, the wafer processing device 11 includes a driving unit 4, a transfer chamber 103, process chambers 100, and a bearing assembly 2. The process chambers 100 are coupled to the transfer chamber 103. The transfer chamber 103 is used to provide a sealed space so that the transfer chamber 103 is set to have a first vacuum condition, the process chamber 100 is used for processing wafers, and the process chamber 100 has a second vacuum condition; the bearing assembly 2 is arranged in the transfer chamber 103, the bearing assembly 2 is used for supporting wafers, and the driving unit 4 has a first driving mechanism for adjusting the position of the bearing assembly 2 in the transfer chamber 103, and a second driving mechanism for driving the bearing assembly 2 to move between the transfer chamber 103 and the process chamber 100. Here, the transfer chamber 103 operates at a transport pressure, generally 0.1 to 0.3 Torr (unit of pressure intensity), and the transfer chamber 103 has a first vacuum condition to match the transport pressure of the transfer chamber 103. The process chamber 100 operates at a process pressure, e.g., 1 Torr (unit of pressure intensity), and the process chamber 100 has a second vacuum condition to match the process pressure of the process chamber 100, i.e., the first vacuum condition of the transfer chamber is different from the second vacuum condition of the process chamber. In other embodiments of the present disclosure, the first vacuum condition of the transfer chamber is the same as the second vacuum condition of the process chamber. In some other embodiments of the present disclosure, the wafer processing device includes a driving unit 4, a transfer chamber 103, a process chamber 100, and a bearing assembly 2. The process chamber 100 is coupled to the transfer chamber 103; the transfer chamber 103 is used for providing a sealed space so that the transfer chamber 103 is set to have a first vacuum condition. The process chambers 100 are used for processing wafers, and the process chambers are defined to at least have a pre-heating chamber 102 and mini processing chamber 101, and the mini processing chamber 101 is set to have a second vacuum condition, the pre-heating chamber 102 is set to have a third vacuum condition. The bearing assembly 2 is arranged in the transfer chamber 103, the bearing assembly 2 is used for supporting wafers, and the driving unit has a first driving mechanism for adjusting the position of the bearing assembly 2 in the transfer chamber 103, and a second driving mechanism for driving the bearing assembly 2 to move between the transfer chamber 103 and the process chambers 100. Here, the transfer chamber 103 can obtain the first vacuum condition by the first air extraction device 9, the mini processing chamber 101 can obtain the second vacuum condition by the second air extraction device, and the pre-heating chamber 102 can obtain the third vacuum condition by the third air extraction device. In particular, the transfer chamber 103 operates at a transport pressure, generally 0.1-0.3 Torr (unit of pressure intensity), and the transfer chamber 103 has a first vacuum condition corresponds to a transport pressure of the transfer chamber 103. The mini processing chamber 101 operates at a process pressure, e.g., 1 Torr (unit of pressure intensity), the mini processing chamber 101 has a second vacuum condition corresponds to the process pressure of the mini processing chamber 101. The pre-heating chamber 102 operates at a heating pressure, for example 0.1-0.3 Torr (unit of pressure intensity), and the pre-heating chamber 102 has a third vacuum condition corresponds to the heating pressure of the pre-heating chamber 102, i.e., the first vacuum condition of the transfer chamber 103 is different from the second vacuum condition of the mini processing chamber 101, and the first vacuum condition of the transfer chamber 103 is the same as the third vacuum condition of the pre-heating chamber 102. In other embodiments of the present disclosure, the first vacuum condition of the transfer chamber 103, the second vacuum condition of the mini processing chamber 101 and the third vacuum condition of the pre-heating chamber 102 may all be the same or may be different.

In some other embodiments, the process chambers 100 are set to have a first pre-heating chamber 102 and a first mini processing chamber 101. The first pre-heating chamber 102 is used for heating a wafer, and the first mini processing chamber 101 is used for processing the wafer. In other specific embodiments, one process chamber 100 is provided, and the process chamber 100 is either the pre-heating chamber 102 or the mini processing chamber 101. In still other embodiments, two process chambers 100 are provided, and the two process chambers 100 are set to be two mini process chambers 101, or the two process chambers 100 are set to be two pre-heating chambers 102, or the two process chambers 100 are set to have one mini processing chamber 101 and one pre-heating chamber 102.

It should be noting that when the process chambers 100 of one wafer processing device 11 are provided as all the pre-heating chambers 102 or all the mini processing chambers 101, the process chambers 100 of the other wafer processing device 11 that can be used in conjunction with the above wafer processing device 11 can be provided as different process chambers 100 than the former process chambers 100 of one wafer processing device 11. For example, the process chambers 100 of the first wafer processing device 11 are all the pre-heating chambers 102, while the process chambers 100 of the second wafer processing device 11 is all the mini processing chambers 101.

In some preferred embodiments of the present disclosure, the mini processing chambers 101 or the pre-heating chambers 102 are provided as at least two, that is, the process chambers are defined to have at least the first pre-heating chamber 102, the second pre-heating chamber (not shown), and the first mini processing chamber 101 and a second mini processing chamber (not shown). The first pre-heating chamber 102 and the second pre-heating chamber (not shown) are used for heating or pre-heating the first and second groups of wafers respectively, and the first mini processing chamber 101 and the second mini processing chamber (not shown) are used for processing the first and second groups of heated or pre-heated wafers respectively. In other specific embodiments, the mini processing chambers 101 are provided as two three or more. In still other embodiments, the pre-heating chambers 102 are provided as two, three or more.

In some embodiments of the present disclosure, the equipment body 1 is provided with the process chambers 100 and the transfer chamber 103, and the driving unit 4 is provided on the equipment body 1. In some embodiments, when the wafer processing device 11 is provided with the mini processing chamber 101 and the pre-heating chamber 102 at the same time, the equipment body 1 is provided with the mini processing chamber 101, the pre-heating chamber 102 and the transfer chamber 103.

In some embodiments of the present disclosure, the process chambers 100 are disposed on an upper or lower face or side of the transfer chamber 103, and the driving unit 4 is disposed on a side of the transfer chamber 103 away from the process chamber 100. In some specific embodiments of the present disclosure, the process chambers 100 are arranged on the upper face or side of the transfer chamber 103, and the driving unit 4 is arranged on the lower face or side of the transfer chamber 103.

In some embodiments of the present disclosure, the bearing assembly 2 are provided as two in order to be able to process one or a group of wafers while heating another or a group of wafers, or to be able to heat another or a group of wafers while processing one or a group of wafers. The two bearing assemblies 2 include a first bearing assembly 202 and a second bearing assembly 3.

In other embodiments, the number of the bearing assemblies 2 may also be set to one. That is, the wafers carried by the bearing assembly 2 can be processed asynchronously by different process chambers 100, and the wafers can be pre-heated or heated and then processed, or the wafers can be pre-heated or heated after the wafers are processed.

It is worth noting that when the pre-heating chambers 102 or the process chambers 101 are both provided with two, three or more, and at least two bearing assemblies 2 are provided, different wafers can be processed synchronously by different bearing assemblies 2, and the wafers may be processed after being heated, or the wafers may be heated after being processed by the bearing assembly 2.

In other embodiments, the number of the bearing assembly 2 may also be set to be greater than the sum of the number of the mini processing chambers 101 and the pre-heating chambers 102. In some embodiments, the number of the carrier components 2 may also be set to three. For example, while one bearing assembly 2 is heated, the other bearing assembly 2 is processed, and the last bearing assembly 2 is used to transport wafers to an external equipment.

It is worth noting that, in practical use, one mini processing chamber 101 and one pre-heating chamber 102 may form a set of process chambers 100, and one or more sets of the process chambers 100 may be provided on one of the wafer processing device 11, so that one or more groups of wafers can be processed at the same time and/or for the same steps at the same time.

In still other specific embodiments of the present disclosure, when the wafer processing device 11 is provided with the mini processing chamber 101 and the pre-heating chamber 102 at the same time, the transfer chamber 103, the mini processing chamber 101 and the pre-heating chamber 102 are provided in the equipment body 1, and the mini processing chamber 101 and the pre-heating chamber 102 are located on the upper side or face of the transfer chamber 103. In other embodiments, the mini processing chamber 101 and the pre-heating chamber 102 may also be located on the underside or bottom face of the transfer chamber 103. In still other embodiments, the mini processing chamber 101 and the pre-heating chamber 102 may also be located on the left or right side of the transfer chamber 103. In further embodiments, the pre-heating chamber 102 and the mini processing chamber 101 may in turn be located on different sides of the transfer chamber 103.

In some embodiments, the mini processing chamber 101 is provided with a shower head, a shower panel or other structure, the shower head is coupled to the feeding mechanism 5 so as to enable the coating, deposition, etching or other processing process of the wafers in the mini processing chamber 101.

In some embodiments, the housing of the mini processing chamber 101 is arranged to be rectangular. In other embodiments, a profile of the mini processing chamber 101 may also be set to be square, circular, polygonal or other shapes. In still other embodiments, the profile of the mini processing chamber 101 may also be set to a regular shape or an irregular shape.

In other embodiments, the mini processing chamber 101 is formed by a first cover 1011 and the equipment body 1, and the first cover 1011 is removably disposed on the equipment body 1. This arrangement facilitates installation and maintenance clean or replacement of the structure within the mini processing chamber 101.

In other embodiments, the pre-heating chamber 102 is formed by a second cover 1021 and the equipment body 1, and the second cover 1021 is removably disposed on the equipment body 1.

In some embodiments, the feeding mechanism 5 is typically provided as a cabinet, and the feeding mechanism 5 is capable of supplying raw materials. In other embodiments, the feeding mechanism 5 can implement the proportion of various ingredients according to a fixed requirement.

In some embodiments, the pre-heating chamber 102 is provided with a heating unit or assembly, and the heating unit or assembly can have the ability of heating the space within the pre-heating chamber 102. In other embodiments, the heating assembly may also be disposed outside the pre-heating chamber 102.

In some embodiments, the housing of the pre-heating chamber 102 is arranged to be circular. In other embodiments, the profile of the pre-heating chamber 102 may also be square, circular, polygonal or otherwise. In still other embodiments, the profile of the pre-heating chamber 102 may also be set to a regular shape or an irregular shape.

In some embodiments, the transfer chamber 103 is coupled to the mini processing chamber 101 and the pre-heating chamber 102. Herein, the couple relates to the following two couple states, taking two bearing assemblies 2 as examples: (1) when the first bearing assembly 202 and the second bearing assembly 3 are respectively located within the pre-heating chamber 102 and the mini processing chamber 101, both the pre-heating chamber 102 and the mini processing chamber 101 are coupled to the transfer chamber 103; (2) when both the first bearing assembly 202 and the second bearing assembly 3 are located within the transfer chamber 103, both the pre-heating chamber 102 and the mini processing chamber 101 are coupled to the transfer chamber 103. In other embodiments, the couple of the transfer chamber 103 to the mini processing chamber 101 and the pre-heating chamber 102 may also include couple of one of the mini processing chambers 101 and the pre-heating chamber 102 to the transfer chamber 103. Specifically, the transfer chamber 103 is coupled to the mini processing chamber 101 and the pre-heating chamber 102, that is, the driving unit 4 can directly drive the first bearing assembly 202 and/or the second bearing assembly 3 to move between the pre-heating chamber 102 and the transfer chamber 103, the driving unit 4 can directly drive the first bearing assembly 202 and/or the second bearing assembly 3 to move between the mini processing chamber 101 and the transfer chamber 103, or the driving unit 4 can transport the first bearing assembly 202 and/or the second bearing assembly 3 to the mini processing chamber 101 through the pre-heating chamber 102, or the driving unit 4 can transport the first bearing assembly 202 and/or the second bearing assembly 3 to the pre-heating chamber 102 through the mini processing chamber 101.

In some embodiments, the first support and the second support may be arranged in the form of a disk, plate, rod or other shape. The first support member and the second support member are movably arranged in the transfer chamber 103, and the driving unit 4 is arranged in the equipment body 1. When in use, the first bearing assembly 202 and the second bearing assembly 3 are driven by the driving unit 4 to move between the mini processing chamber 101, the pre-heating chamber 102 and the transfer chamber 103. The movement between the mini processing chamber, the pre-heating chamber and the transfer chamber includes: driving the bearing assembly 2 to move between the mini processing chamber 101 and the transfer chamber 103, driving the bearing assembly 2 to move between the pre-heating chamber 102 and the transfer chamber 103, driving the bearing assembly 2 to move between the mini processing chamber 101 and the pre-heating chamber 102, driving the bearing assembly 2 to move between one of the processing chambers 101 and another of the process chambers 101, and driving the bearing assembly 2 to move between one of the pre-heating chambers 102 and another of the pre-heating chambers 102.

It is worth noting that when the bearing assembly 2 moves directly between the mini processing chamber 101 and the pre-heating chamber 102, between one of the mini processing chambers 101 and another of the mini processing chambers 101, or between one of the pre-heating chambers 102 and another of the pre-heating chambers 102, switches can be arranged between the mini processing chambers 101 and the pre-heating chambers 102, between the mini processing chambers 101 and the mini processing chambers 101, or between the pre-heating chambers 102 and the pre-heating chambers 102 to control on-off between two adjacent chambers.

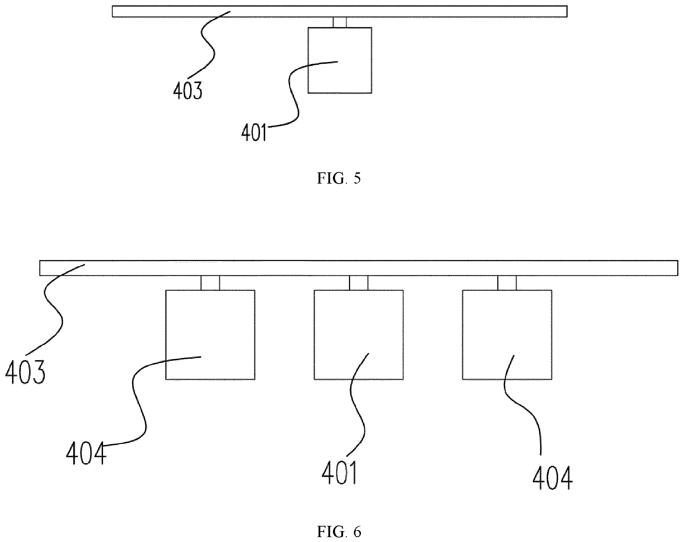

FIG. 5 is a structural diagram of a first driving mechanism in a second embodiment of the present disclosure.

In some embodiments of the present disclosure, the driving unit 4 includes a first driving mechanism 401, a second driving mechanism 402 and a transfer 403. The transfer 403 is arranged in the transfer chamber 103, the first driving mechanism 401 is coupled to the transfer 403, and the first driving mechanism 401 is used for driving the transfer 403 to move or rotate at an angle. The bearing assembly 2 is arranged on the transfer 403, and the second driving mechanism 402 is arranged on one side of the transfer 403. The second driving mechanism 402 is used to drive the bearing assembly 2 to move between the process chamber 100 and the transfer chamber 103.

Specifically, when the process chamber 100 is the mini processing chamber 101 and/or the pre-heating chamber 102, the second driving mechanism 402 is used to drive the bearing assembly 2 to move between the mini processing chamber 101 and the transfer chamber 103, and/or the second driving mechanism 402 is used to drive the bearing assembly 2 to move between the pre-heating chamber 102 and the transfer chamber 103.

In some specific embodiments of the present disclosure, the transfer 403 is provided as a support plate, the transfer 403 is provided with a hollow region, and the bearing assembly 2 is provided at the hollow region. The first driving unit 4 is a rotating motor, and the rotating shaft of the rotating motor is coupled to the transfer 403, so that the transfer 403 can rotate along with the rotation of the rotating motor, thereby driving the bearing assembly 2 to rotate horizontally, that is, this can adjust the position of the bearing assembly 2 in a horizontal plane.

By adjustment, the bearing assembly 2 can be moved from a first position on the lower side of the mini processing chamber 101 to a second position on the lower side of the pre-heating chamber 102. The bearing assembly 2 can also be moved from a first position on the lower side of the pre-heating chamber 102 to a second position on the lower side of the mini processing chamber 101 by adjustment.

The second driving mechanism 402 is an electric cylinder, an air cylinder, a worm wheel or other structure. The second driving mechanism 402 is vertically arranged. When in use, the second driving mechanism 402 can drive the first bearing assembly 202 and/or the second bearing assembly 3 to move upwardly and/or downwardly, that is, this can adjust the high and low positions of the bearing assembly 2 so as to achieve the movement of the first bearing assembly 202 and the second bearing assembly 3 among the mini processing chamber 101, the pre-heating chamber 102 and the transfer chamber 103.

In some embodiments, a fixed portion of the second driving mechanism 402 is disposed at a lower side of the transfer chamber 103, and a movable portion of the second driving mechanism 402 is disposed within the transfer chamber 103. This arrangement can reduce the size of the space of the transfer chamber 103, and can avoid the space of the transfer chamber 103 being too large, which will increase the difficulty of manufacturing, or the difficulty of manufacturing the required environment of the transfer chamber 103.

In other embodiments, the first driving mechanism 401 and/or the second driving mechanism 402 may also be disposed in a front, rear, left, right or other direction of the transfer chamber 103.

In some specific embodiments, an inner diameter of the hollow portion is smaller than the outer diameter of the bearing assembly 2, so that the bearing assembly 2 can be lowered to the transfer 403 as the movable portion of the second driving mechanism 402 is lowered, and to be restrained by the transfer 403 so that the movable portion of the second driving mechanism 402 can be separated from the bearing assembly 2, and vice versa.

FIG. 6 is a schematic structural diagram of a third driving mechanism in a second embodiment of the present disclosure.

In some embodiments of the present disclosure, the transfer 403 is detachably connected to the first driving mechanism 401. The driving unit 4 also includes a third driving mechanism 404. The third driving mechanism 404 is arranged at one side of the transfer 403, and the third driving mechanism 404 is used for driving the transfer 403 and the bearing assembly 2 to move.

In some specific embodiments of the present disclosure, an irregular protrusion is arranged on the lower side or face of the transfer 403, a groove fitting with the irregular protrusion is arranged at the movable end of the first driving mechanism 401, the transfer and the first driving mechanism 401 are connected therewith by the protrusion and the groove, and the third driving mechanism 404 is arranged on the lower side or face of the transfer 403. In use, the third driving mechanism 404 lifts the transfer 403 upwardly so that the transfer 403 is separated from the first driving mechanism 401, that is, the bearing assembly 2 is moved between the transfer chamber 103 and the process chamber 100 by the third driving mechanism 404 instead of the second driving mechanism 402.

In other embodiments, the driving unit 4 further comprises a couple mechanism (not shown). The couple mechanism is arranged on the bearing assembly 2 or the transfer 403, the couple mechanism (not shown) is provided with a first clamping part, the bearing assembly 2 or the transfer 403 is provided with a second clamping part fitting with the first clamping part, and the couple mechanism is used for coupling the transfer 403 to the connecting piece. When in use, the bearing assembly 2 and the transfer 403 are integrated by the first clamping part clamped to the second clamping part via the couple mechanism, so that the transfer 403 can achieve linkage effect when the second driving mechanism 402 drives the bearing assembly 2 to move, and then all the bearing assemblies 2 on the transfer 403 can move upwardly or downwardly synchronously.

In some embodiments of the present disclosure, the seal between the driving unit 4 and the equipment body 1 is a dynamic seal. In some specific embodiments of the present disclosure, the dynamic seal may be in the form of a magnetic fluid seal. In this way, the inactive portion of the second driving mechanism 402 is integrally arranged outside the transfer chamber 103, so that impurity substance exists between the fixed portion and the movable portion of the second driving mechanism 402 can be reduced from entering into the transfer chamber 103.

In other embodiments, the transfer 403 may be in the form of a belt or crawler conveyor on which the bearing assembly 2 is disposed. The first driving mechanism 401 is provided as a robot arm, a clamping mechanism, or other mechanism, and the first driving mechanism 401 enables the first bearing assembly 202 and/or the second bearing assembly 3 to be moved onto the second driving mechanism 402. The second driving mechanism 402 drives the bearing assembly 2 to move into the mini processing chamber 101 or the pre-heating chamber 102.

In some embodiments of the present disclosure, at least two process chambers 101 are provided, and at least two bearing assemblies 2 are provided. In other embodiments, the first bearing assembly 202 or the second bearing assembly 3 are provided with at least two. At least two of the second driving mechanisms 402 are provided, and each of the second driving mechanisms 402 operates or works independently.

In some specific embodiments of the present disclosure, the process chambers 101 are provided with two, one pre-heating chamber 102 is provided therewith, and each of the first bearing assembly 202 and the second bearing assembly 3 are provided with two. Four second driving mechanisms 402 are provided therewith, and the four second driving mechanisms 402 operate or works independently.

It is worth noting that when the heating conditions are the same, a plurality of the bearing assemblies 2 can be arranged in the common pre-heating chamber 102 for the pre-heating or heating process, so that the number of the pre-heating chambers 102 can still be set to one when the bearing assemblies 2 are set to be plural.

In addition, when the bearing assemblies 2 is provided with one and the second driving mechanisms 402 are provided with two, both of the second driving mechanisms 402 are used to drive the movement of the bearing assemblies 2. For example, the first second driving mechanism 402 drives the bearing assembly 2 to move to the pre-heating chamber 102, and the second driving mechanism 402 drives the bearing assembly 2 to move to the mini processing chamber 101.

In other embodiments, the mini processing chamber 101 may be provided with one, three, four or other number.

In other embodiments, the pre-heating chambers 102 may be provided with two three or other numbers.

In other embodiments, both the first bearing assembly 202 and the second bearing assembly 3 may be provided with one, three, four or other number.

In other embodiments, the second driving mechanism 402 may be provided with one, two, three, four or other number. It is worth mentioning that the same second driving mechanism 402 can be arranged to simultaneously control the lifting of the bearing assembly or assemblies 2 with two, three or more positions in actual arrangement. For example, five bearing assemblies 2 are provided, and two second driving mechanisms 402 are provided, one of the second driving mechanisms 402 controls the lifting of two of the bearing assemblies 2, and the other of the second driving mechanisms 402 controls the lifting of three of the bearing assemblies 2.

In other embodiments, two second driving mechanisms 402 may control the lifting of the same bearing assembly.

In some embodiments of the present disclosure, each of the bearing assemblies 2 is provided with N support portions 201, and the support portions 201 are used for supporting the wafer or wafers, and N is an integer greater than 1.

In some specific embodiments of the present disclosure, the bearing assembly 2 is provided with twenty-five support portions 201 so that twenty-five wafers can be arranged simultaneously on the common bearing assembly 2.

In other embodiments, the support portion 201 may also be provided with any other number.

In some embodiments of the present disclosure, the wafer processing device further includes a seal (not shown) provided on the bearing assembly 2, the seal or sealing assembly is used for separating the transfer chamber 103 from the mini processing chamber 101 and/or the pre-heating chamber 102.

In some specific embodiments of the present disclosure, the seal or sealing assembly (not shown) is disposed on the first bearing assembly 202 and the second bearing assembly 3, and when the first or second support moves into the mini processing chamber 101 or the pre-heating chamber 102, the side of the seal abuts against the side walls of the mini processing chamber 101 or the pre-heating chamber 102. At this time, the seal and the first bearing assembly 202 or the second bearing assembly 3 isolate the mini processing chamber 101/and or the pre-heating chamber 102 from the transfer chamber 103. When heating, only the wafer or wafers in the pre-heating chamber 102 is heated, and when processing, only the wafer or wafers in the mini processing chamber 101 is processed.

In other embodiments, a movable plate, a gate valve or other structural member may be provided at the joint of the mini processing chamber 101 and/or the pre-heating chamber 102 and the transfer chamber 103, and the movable plate, the gate valve or the other structural member may be driven to move by providing a moving mechanism. When the first bearing assembly 202 and/or the second bearing assembly 3 are located in the transfer chamber 103, the communication between the mini processing chamber 101 and/or the pre-heating chamber 102 with the transfer chamber 103 can still be cut off by the movable plate, the gate valve or other structural members.

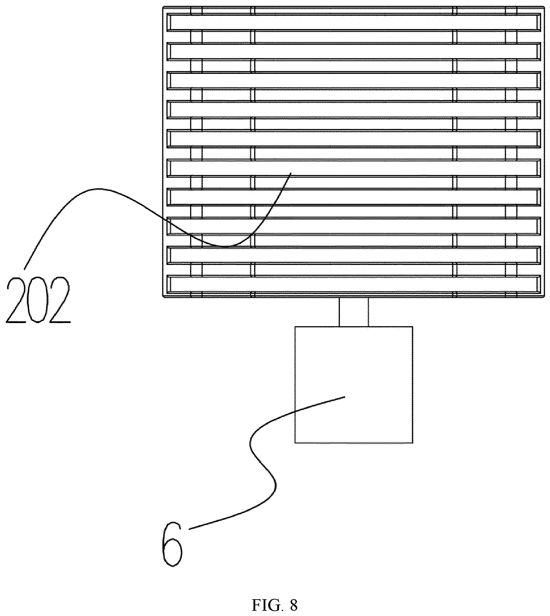

FIG. 8 is a schematic structural diagram of a fourth driving mechanism in a fourth embodiment of the present disclosure.

In some embodiments of the present disclosure, the wafer processing device further includes a fourth driving mechanism 6. The fourth driving mechanism 6 is arranged on one side of the bearing assembly 2, and the fourth driving mechanism 6 is used for driving the bearing assembly 2 to rotate at an angle. In some embodiments, the fourth driving mechanism 6 is arranged on one side of the bearing assembly 2, and the fourth driving mechanism 6 is used for driving the bearing assembly 2 to rotate at an angle.

In some embodiments of the present disclosure, the third driving mechanism 404 is disposed within the transfer chamber 103. The third driving mechanism 404 is a rack-and-pinion mechanism, the gear of the third driving mechanism 404 is arranged on the first bearing assembly 202 or the second bearing assembly 3, the rack of the third driving mechanism 404 is arranged in the transfer chamber 103, and the gear of the third driving mechanism 404 is coupled to the rack. When in use, the third driving mechanism drives the rack to move, and drives the first bearing assembly 202 and/or the second bearing assembly 3 to rotate at a certain angle by the gear.

In some embodiments, the fourth driving mechanism 6 may be provided as one or more, and when the fourth driving mechanism 6 is provided as one, the wafer processing position corresponding to the fourth driving mechanism 6 is provided with a rotation function or an angle adjustment function. In other embodiments, a plurality of the fourth driving mechanisms 6 may be provided, and the fourth driving mechanisms 6 are provided in one-to-one correspondence with the bearing assemblies 2.

It is worth noting that in order to avoid interference between the third driving mechanism 404 and the second driving mechanism 402, the third driving mechanism 404 and the transfer 403 may be set at different heights. In still other embodiments, the third driving mechanism 404 may also be disposed on the transfer 403.

In other embodiments, the third driving mechanism 404 may also be provided in the form of two gears.

In still other embodiments, the third driving mechanism 404 may also be disposed within the movable end of the second driving mechanism 402, in which case the third driving mechanism 404 may be provided as a rotating cylinder, rotating motor or other driver. It is worth mentioning that when the third driving mechanism 404 is arranged on the second driving mechanism 402, the third driving mechanism 404 will move along with the movement of the movable end of the second driving mechanism 402.

In some embodiments of the present disclosure, the wafer processing device includes a fifth driving mechanism 7. The equipment body 1 includes a first fixing part 104 and a second fixing part 105. The mini processing chamber 101 and the pre-heating chamber 102 are arranged on the first fixing part 104, and the first fixing part 104 and the second fixing part 105 are configured to form the transfer chamber 103. The fifth driving mechanism 7 is arranged on the first fixing part 104 and/or the second fixing part 105, and the fifth driving mechanism 7 is used for driving the first fixing part 104 or the second fixing part 105 to move.

In some specific embodiments of the present disclosure, the first fixing part 104 is arranged on the upper side or face of the second fixing part 105, and the mini processing chamber 101 and the pre-heating chamber 102 are arranged on the upper side or face of the first fixing part 104. The first fixing part 104 and the second fixing part 105 are defined to form the transfer chamber 103, which is thus surrounded by the first fixing part 104 and the second fixing part 105. The fifth driving mechanism 7 is an air cylinder, an electric cylinder or other mechanism. One end of the fifth driving mechanism 7 is fixed to the second fixing part 105. When in use, by opening the fifth driving mechanism 7, the movable end of the fifth driving mechanism 7 is moved to fit with the first fixing part 104, and as the fifth driving mechanism 7 continues to open, the fifth driving mechanism 7 lifts the first fixing part 104 upwardly, thereby opening the transfer chamber 103. At this time, the structure in the transfer chamber 103 can be cleaned, repaired or replaced. When it is necessary to control the switching chamber 103 to close, the fifth driving mechanism 7 is controlled to move in the reverse direction, and the first fixing part 104 is automatically lowered and attached to the second fixing part 105 under the action of gravity.

In other embodiments, a top end of the fifth driving mechanism 7 can be fixed to the first fixing part 104, so that the first fixing part 104 and the second fixing part 105 will be in a contact state along with the contraction of the fifth driving mechanism 7.

In still other embodiments, the position relationship between the first fixing part 104 and the second fixing part 105 may be in a front-back direction or a left-right direction. In still other embodiments, the position relationship between the first fixing part 104 and the second fixing part 105 may also be in an inclined direction.

In other embodiments, a seal or seal assembly may be arranged between the first fixing part 104 and the second fixing part 105 to seal and improve the gas tightness.

In still other embodiments, a plurality of the fifth driving mechanism 7 may be provided.

In some embodiments of the present disclosure, the wafer processing device further includes a heating unit 8. The heating unit 8 is connected to the transfer chamber 103, and the heating unit 8 is used for heating the transfer chamber 103.

In some specific embodiments of the present disclosure, the heating unit 8 is arranged in the transfer chamber 103, and the heating unit 8 can generate heat to heat the transfer chamber 103.

In some embodiments, the heating unit 8 may be provided in the transfer chamber 103 in the form of a heating plate, a heating wire or a heating sheet. In other embodiments, the heating unit 8 may also be provided in the form of a heating pipe or a heating rod. In other embodiments, the heating unit 8 may also be provided as a means for emitting light which irradiates the wafer to generate heat. For example, the light is infrared light.

In some embodiments of the present disclosure, the wafer processing device further includes a first air extraction device 9. The first air extraction device 9 is coupled to the transfer chamber 103, and the first air extraction device 9 is used for extracting the gas in the transfer chamber 103.

In some specific embodiments of the present disclosure, the transfer chamber 103 is provided with a nozzle by which the first air extraction device 9 is coupled to the transfer chamber 103. Due to ensuring that the transfer chamber 103 is in a vacuum state in use, the first air extraction device 9 is provided to facilitate the extraction of the gas in the transfer chamber 103, thus achieving the vacuum state of the transfer chamber 103.

In some embodiments of the present disclosure, the water processing device further includes a second air extraction device (not shown). The second air extraction device is coupled to the process chamber 100, and the second air extraction device is used for extracting the gas in the process chamber 100.

In some embodiments of the present disclosure, the process chamber 100 is provided with air holes by which the second air extraction device (not shown) communicates with the process chamber 100.

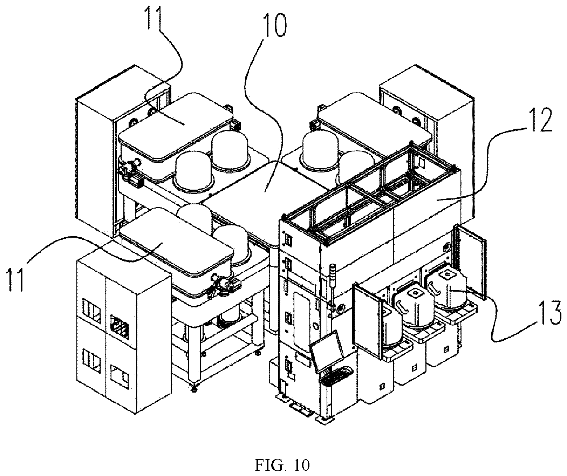

FIG. 10 is a stereoscopic structural schematic diagram of a wafer processing system in the embodiments of the present disclosure.

In some embodiments of the present disclosure, the wafer processing system includes a transport device 10 and the wafer processing device 11 described in any of the above embodiments. The wafer processing device 11 is provided with a transport channel, the transport device 10 communicates with the transport channel, and the transport device 10 is used for transporting the wafers.

In some specific embodiments of the present disclosure, the transport channel is provided between the transport device 10 and the wafer processing device 11, the transport device 10 is provided with a robot arm and a driving part, and the robot arm can be driven to move by the driving part. When in use the transport device 10 can transfer an external wafer to the wafer processing device 11. Alternatively, the transport device 10 can transfer the wafer of the wafer processing device 11 to the outside.

In some embodiments of the present disclosure, as at least two wafer processing devices 11 are provided, and the wafer processing devices 11 are provided on different sides of the transport device 10, the transport device 10 is used for transporting wafers to each of the wafer processing devices 11, and the transport device 10 is used for transporting wafers of each of the wafer processing devices 11.

In some specific embodiments of the present disclosure, three wafer processing devices 11 are provided, and the three wafer processing devices 11 are arranged around a periphery of the transport device 10, and transport channels are provided between the transport device 10 and the three wafer processing devices 11. The transport device 10 is capable of taking and feeding wafers to the three wafer processing devices 11.

In other embodiments, one of the wafer processing devices 11 on the circumferential side of the transport device 10 may also be provided in two, four, five or other numbers.

In some embodiments of the present disclosure, the water processing system further includes a front processing device 12. The front processing device 12 is arranged on a side of the transport device 10, the front processing device 12 is provided with a wafer circulating box (not shown), the transport device 10 transports the wafers to the wafer circulating box and/or the wafer processing device 11, and the front processing device 12 is used for transporting the wafer circulating box.

In some specific embodiments of the present disclosure, by providing the front processing device 12 and arranging the front processing device 12 on a side of the transport device 10, the transport device 10 can take and place wafers from/to the front processing device 12.

Due to the use requirements, the wafer needs to be moved in a dust-free or vacuum environment. The wafer circulating box (not shown) is provided in the front processing device 12 so that the wafer can be transported by the wafer circulating box when being transferred. Specifically, a vacuum or dust-free environment may be provided within the front processing device 12. The wafers of the wafer processing device 11 are placed in the wafer circulating box in the front-end processing apparatus 12, or the external wafers are transported to the front-end processing apparatus 12 by the wafer circulating box and then transported to the transport device 10 or the wafer processing device 11, thereby preventing the wafers from contacting the outside.

In another embodiment, a clamping mechanism, a grabbing mechanism, or other transfer mechanism may be provided within the front processing device 12, and wafer movement between the wafer circulating box and the transport device 10 may be implemented by the above mechanism.

In some embodiments of the present disclosure, the water processing system also include a wafer transport box 13 and a transport device (not shown). The wafer transport box 13 is arranged at the front processing device 12, and the front processing device 12 is used for conveying the wafer circulating box to the wafer transport box 13. The transport device is used for conveying the wafer transport box 13.

In some embodiments of the present disclosure, the wafer transport box 13 is movably attached to the front processing device 12. When in use, the wafer circulating box is transported into the wafer transport box 13, and then the wafer transport box 13 is transferred by the transport device (not shown). Alternatively, the wafer circulating box within the wafer transport box 13 is transferred to the front processing device 12 by the transport device. This arrangement allows the wafer circulating box to be transferred by the wafer transport box 13, thereby reducing the possibility of pollution of the wafer or wafers. At the same time, the transport device is arranged to facilitate the transfer of the wafer transport box 13.

In other embodiments, a switching mechanism may be provided on the wafer transport box 13. When the wafer transport box 13 is transported to the front processing device 12 or other device, the switching mechanism is controlled to open so that the wafer transport box within the front processing device can be taken out.

In some other embodiments, the front processing device 12 may be provided with a structure identical with the switching mechanism, so as to limit the input and output of the wafer circulating box and to improve the sealing effect of the front processing device 12.

In a first embodiment of the present disclosure, a control method suitable for the wafer processing device is provided. Please refer to FIG. 3 as follows:
Step 1. transporting the first group of wafers and the second group of wafers simultaneously or at the same time to a first position and a second position of the transfer chamber 103 by a robot arm (not shown), wherein the first position and the second position of the transfer chamber 103 are arranged corresponding to the first pre-heating chamber 102 and the second pre-heating chamber (not shown) in the process chambers;
Step 2. driving, by the driving unit 4, a first carrier or first bearing assembly (not shown) coupled to the robot arm (not shown) to enable the first group of wafers at the first position and the second group of wafers at the second position of the transfer chamber 103 to be moved upwardly to the first pre-heating chamber 102 and the second pre-heating chamber (not shown) of the process chambers respectively for the pre-heating or heating process;
Step 3. driving, by the driving unit 4, a rotary bracket (not shown) coupled to the first carrier or first bearing assembly (not shown) to enable the first group of pre-heated or heated wafers and the second group of pre-heated or heated wafers to be moved to a third position and a fourth position of the transfer chamber 103, wherein the third position and the fourth position of the transfer chamber 103 are arranged corresponding to the first mini processing chamber 101 and the second mini processing chamber (not shown) of the process chambers; and
Step 4. driving, by the driving unit 4, a second carrier or second bearing assembly (not shown) coupled to the rotary bracket (not shown) to enable the first group of wafers at the third position and the second group of wafers at the fourth position in the transfer chamber 103 to be moved upwardly to the first mini processing chamber 101 and the second mini processing chamber (not shown) of the process chambers respectively for the processing process.

In the first embodiment of the present disclosure, the first carrier, the rotary bracket and the second carrier are components or units of the bearing assembly, and the first carrier, the rotary bracket and the second carrier are arranged in the transfer chamber 103. The first carrier and the second carrier are in the form of assembly.

In the above-mentioned first embodiment of the present disclosure, the driving unit includes one or more driving mechanisms to realize the following functions: driving a first carrier (not shown) to enable the first group of wafers at the first position of the transfer chamber 103 and the second group of wafers at the second position of the transfer chamber 103 to be moved to the first pre-heating chamber 102 and the second pre-heating chamber (not shown) of the process chambers for the pre-heating process or treatment; driving the rotary bracket (not shown) to enable the first group of wafers and the second group of wafers that have been pre-heated or heated to be moved to the third position and the fourth position of the transfer chamber 103; and driving a second carrier (not shown) to enable the first group of wafers at the third position and the second group of wafers at the fourth position within the transfer chamber 103 to be moved to the first mini processing chamber 101 and the second mini processing chamber (not shown) of the process chambers respectively for the processing process. Specifically, referring to FIG. 1 and FIG. 2, a semiconductor equipment comprises a reaction chamber unit, wherein a sinking space is arranged in the reaction chamber unit, a rotary bracket is arranged in the sinking space, and four work-stations or a plurality of work-stations are arranged on the rotary bracket, and an upper cover plate is also arranged in the sinking space.

Each workstation is used for placing a wafer boat. For example, the wafer boat can carry wafers, i.e., 50 wafers, and there are a pre-heating chamber A and a pre-heating chamber B, a mini processing chamber A and a mini processing chamber B are arranged above the upper cover plate.

The first group of wafers and the second group of wafers are simultaneously transferred to the sinking space by the robot arm, and then the lifting mechanism in the driving unit lifts the wafer boat (i.e. the first group of wafers and the second group of wafers) upwardly to the pre-heating chamber A and the pre-heating chamber B for the pre-heating or heating treatment, and the pre-heating or heating treatment is carried out at least within a first predetermined time, for example, about 30 min. After the pre-heating or heating treatment, the wafer boat is lowered into the sinking space by the lifting mechanism in the driving unit, and when the rotary bracket is rotated at a certain angle, for example, 180 degrees, and is then sent to the mini processing chamber A and the mini processing chamber B for the processing process, and the processing process or treatment is carried out at least within a second predetermined time, for example, about 1 hour. Note that at the same time of the processing treatment for the first group and second group of wafers, the robot arm continues to transfer new groups of wafers to another available wafer boat, and then enables the new groups of wafers to be entered into the pre-heating chamber A and the pre-heating chamber B for the pre-heating or heating treatment. After the preheating and processing treatment for the former first and second groups of wafers are completed, the former wafer boat is dropped into the sinking space, the rotary bracket is rotated at a certain angle, such as 180 degrees, the pre-heated and processed wafers, i.e. the former first group and second group of completed wafers, are transmitted out by the robot arm, and the new groups of pre-heated wafers continues to enter the mini processing chamber A and the mini processing chamber B for the processing process. Then the above steps are recycled.

In other application scenarios, positions of pre-heating chambers and mini processing chamber can be exchanged, and the pre-heating chamber can be used as a post processing chamber at which different process processes can be set according to process requirements.

In a second embodiment of the present disclosure, a control method suitable for the wafer processing device is provided as follows:
Step 1. transporting, by a bearing assembly (e.g., a robot arm), the first group of wafers and the second group of wafers simultaneously to the first position and the second position in the transfer chamber 103, wherein the first position and the second position in the transfer chamber 103 are arranged corresponding to the first pre-heating chamber 102 and the second pre-heating chamber (not shown) of the process chambers;
Step 2. driving, by the driving unit 4, the bearing assembly (e.g., the robot arm) to move the first group of wafers at the first position and the second group of wafers at the second position in the transfer chamber 103 upwardly to the first pre-heating chamber and the second pre-heating chamber in the process chambers for the pre-heating or heating treatment;
Step 3. driving, by the driving unit, the bearing assembly (e.g., the rotary bracket) to enable the first group of pre-heated or heated wafers and second group of pre-heated or heated wafers to be moved to a third position and a fourth position in the transfer chamber 103, wherein the third position and the fourth position in the transfer chamber 103 are arranged corresponding to the first mini processing chamber 101 and the second mini processing chamber (not shown) of the process chambers; and
Step 4. driving, by the driving unit 4, the bearing assembly (e.g., the robot arm) to enable the first group of pre-heated or heated wafers at the third position and the second group of pre-heated or heated wafers at the fourth position in the transfer chamber 103 to be moved upwardly to the first mini processing chamber 101 and the second mini processing chamber (not shown) of the process chambers for the processing process.

In the above-described second embodiment of the present disclosure, the bearing assembly comprises one or more robot arms and one or more rotary brackets. The driving unit 4 includes one or more driving mechanisms to achieve the above functions.

In a third embodiment of the present disclosure, a control method suitable for the wafer processing device is provided as follows:
Step 1. transporting, by the bearing assembly (e.g., a robot arm), the first group of wafers and the second group of wafers simultaneously to the first position and the second position in the transfer chamber 103, wherein the first position and the second position in the transfer chamber 103 are arranged corresponding to the first mini processing chamber 101 and the second mini processing chamber (not shown) in the process chambers;
Step 2. driving, by the driving unit 4, the bearing assembly (e.g., the rotary bracket) to enable the first group of wafers at the first position and the second group of wafers at the second position in the transfer chamber 103 to be moved upwardly to the first mini processing chamber 101 and the second mini processing chamber (not shown) in the process chambers for the processing treatent;
Step 3, driving, by the driving unit, the bearing assembly (e.g., the rotary bracket) to enable the first group of processed wafers and the second group of processed wafers to be moved to a third position and a fourth position in the transfer chamber 103, wherein the third position and the fourth position in the transfer chamber 103 are arranged corresponding to the first heating chamber 102 and the second heating chamber (not shown) in the process chambers; and
Step 4, driving, by the driving unit 4, the bearing assembly (e.g., the rotary bracket) to enable the first group of processed wafers at the third position and the second group of processed wafers at the fourth position in the transfer chamber 103 to be moved upwardly to the first heating chamber 102 and the second heating chamber (not shown) of the process chambers for the heating treatment.

In the above-described third embodiment of the present disclosure, the bearing assembly includes one or more robot arms and one or more rotary brackets. The driving unit 4 includes one or more driving mechanisms to achieve the above functions.

The second embodiment of the present disclosure discloses performing the pre-heating or heating treatment conducted before the processing treatment, while the third embodiment of the present disclosure discloses performing the processing treatment conducted before the heating treatment, which is determined according to different wafer processing processes.

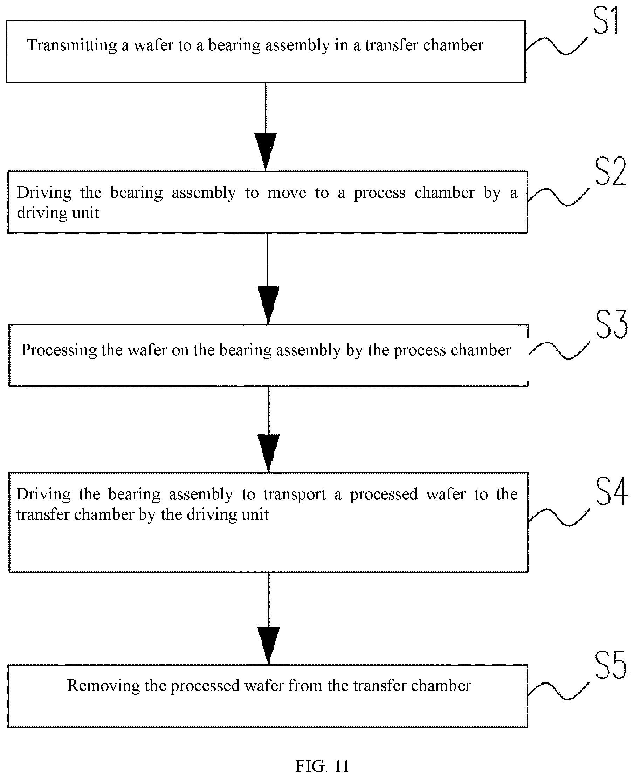

FIG. 11 is a flow diagram of a control method of the wafer processing device in the above embodiments of the present disclosure.

The embodiments of the present disclosure also provide a control method of the wafer processing device. The control method is used for controlling the wafer processing device in any of the above embodiments, which includes:
S 1. transmitting a wafer to a bearing assembly 2 in a transfer chamber 103, wherein a first air extraction device is coupled to the transfer chamber, and the first air extraction device is configured to extract gas in the transfer chamber to carry out a first vacuum treatment on the transfer chamber;
S2. driving the bearing assembly 2 to move to a process chamber 100 by a driving unit 4, wherein a second air extraction device is coupled to the process chamber, and the second air extraction device is configured to extract gas in the process chamber to carry out a second vacuum treatment on the process chamber;
S3. processing the wafer on the bearing assembly 2 by the process chamber 100;
S4. driving the bearing assembly 2 to transport a processed wafer to the transfer chamber 103 by the driving unit 4; and
S5. removing the processed wafer from the transfer chamber 103.

In some specific embodiments of the present disclosure, the wafer processing device 11 is typically used in conjunction with a front processing device 12 and a transport device 10. When wafers need to be processed, the front processing device 12 is to transfer the processed or unprocessed wafers, to transport the unprocessed wafer to the bearing assembly 2 of the wafer processing device 11 by the transport device 10, and then the driving unit 4 is to drive the bearing assembly 2 to move upwardly or downwardly into the process chamber 100, so that the wafers on the bearing assembly 2 are processed, then the driving unit 4 controls the bearing assembly 2 to lower to the space of the transfer chamber 103 after the processing process, and the processed wafer is transferred to the front processing device 12 by the transport device 10 so as to finish a complete process for the wafers.

In some embodiments of the present disclosure, the driving unit 4 includes a first driving mechanism 401, a second driving mechanism 402 and a transfer 403; S2 specifically comprises:
S21. driving, by the first driving mechanism 401, the bearing assembly 2 on the transfer 403 to move, and adjusting a position of the bearing assembly 2 in the transfer chamber 103; and
S22. driving, by the second driving mechanism 402, the bearing assembly 2 to move to the process chamber 100.

In some specific embodiments of the present disclosure, the second driving mechanism 402 drives the transfer 403 to rotate horizontally, thereby adjusting the positions of the bearing assembly 2 on the transfer 403, so that a common bearing assembly 2 can provide different positions corresponding to different the mini processing chambers 100, and by the second driving mechanism 402, the bearing assembly 2 can be transported into different mini processing chambers 100 for the processing processes.

In some embodiments of the present disclosure, the process chamber or chambers 100 are disposed on an upper or lower face or side of the transfer chamber 103, and the driving unit 4 is disposed on a side of the transfer chamber 103 away from the process chamber or chambers100.

The step S22 specifically comprises: driving, by the second driving mechanism 402, the bearing assembly 2 to move to the process chambers 100 in an upwardly or downwardly direction.

In some specific embodiments of the present disclosure, the process chamber or chambers 100 are arranged on the upper face or side of the transfer chamber 103, and the driving unit 4 is arranged on the lower face or side of the transfer chamber 103. When in use, the second driving mechanism 402 drives the bearing assembly 2 to move upwardly or downwardly, so as to realize the movement of the bearing assembly 2 between the transfer chamber 103 and the process chamber or chambers 100.

In some embodiments of the present disclosure, at least two second driving mechanisms 402 are provided, and the second driving mechanisms 402 operates or works independently.

The step S22 further includes: driving, by the at least two second driving mechanisms 402, the bearing assembly 2 to move to the process chamber 100 in an up or down direction.

In some specific embodiments of the present disclosure, when the bearing assemblies 2 are located on the lower side of wafers at different processing positions or regions, the lifting control is respectively carried out by different second driving mechanisms 402, so as to facilitate the control of wafers at different processing positions or the bearing assemblies 2.

In some embodiments of the present disclosure, a plurality of process chambers 100 are provided, and the process chambers 100 operates independently, and the plurality of the process chambers 100 are defined to have at least a first pre-heating chamber 102 and a first mini processing chamber 101.

The step S2 and the step S3 specifically comprise:
S31. driving, by the driving unit 4, the bearing assembly 2 to move to the first pre-heating chamber 102, to pre-heat or heat the wafer on the bearing assembly 2; and
S32. driving, by the driving unit 4, the bearing assembly 2 to move to a first mini processing chamber 101, and carrying out a first processing treatment on the wafer on the bearing assembly 2.

In some specific embodiments of the present disclosure, by providing a plurality of the process chambers 100, different processing processes are facilitated by different mini processing chambers 100, and by providing at least one pre-heating chamber 102 and at least one mini processing chamber 101, the same wafer or wafers can be pre-heated or heated and processed in the common wafer processing device 11.

In some embodiments of the present disclosure, the pre-heating chamber 102 and the mini processing chamber 100 are each provided as two;
the step S31 specifically comprises:
   S311. driving, by the driving unit 4, the bearing assembly 2 to enable the bearing assembly 2 to be moved to a first pre-heating chamber 102 to pre-heat or heat the wafers on the bearing assembly 2 for a first predetermined time; and
   S312. driving, by the driving unit 4, the bearing assembly 2 to enable the bearing assembly 2 to be moved to a second pre-heating chamber 102 to pre-heat or heat the wafers on the bearing assembly 2 for the second predetermined time;
the step S32 specifically comprises:
   S321. driving, by the driving unit 4, the bearing assembly 2 to enable the bearing assembly 2 to be moved to a first mini processing chamber 101, and carrying out a first processing treatment on the wafers on the bearing assembly 2; and
   S322. driving, by the driving unit 4, the bearing assembly 2 to enable the bearing assembly 2 to be moved to a second mini processing chamber 101, and carrying out a second processing treatment on the wafers on the bearing assembly 2.

In some specific embodiments of the present disclosure, two pre-heating chambers 102 and two process chambers 100 are provided so that the wafers on the common bearing assembly 2 can be pre-heated or processed step by step using different pre-heating chambers 102 and different mini processing chambers 101.

In some embodiments of the present disclosure, the bearing assembly 2, the pre-heating chamber 102 and the mini processing chamber 100 are each provided in two;
the step S31 specifically comprises: driving, by the driving unit 4, the two bearing assemblies 2 to enable the two bearing assemblies to be moved to the two pre-heating chambers 102 respectively, and pre-heating or heating a first group of wafers and a second group of wafers on the two bearing assemblies 2 in a first pre-heating chamber 102 and a second pre-heating chamber respectively at least within a first predetermined time; and
the step S32 specifically comprises: driving, by the driving unit 4, the two bearing assemblies 2 to enable the two bearing assemblies to be moved to the two process chambers 101 respectively, and processing the first group of wafers and the second group of wafers on the two bearing assemblies 2 in a first mini processing chamber 101 and a second mini processing chamber respectively at least within a second predetermined time.

In some specific embodiments of the present disclosure, two bearing assemblies 2, two pre-heating chambers 102 and two process chambers 100 are provided so that two groups or two pieces of wafers can be processed synchronously by different bearing assembly 2, i.e., two groups of or two pieces of wafers being simultaneously pre-heated or simultaneously processed, or one group of wafers or one wafer being heating while another group of wafers or another wafer being processed.

While the embodiments of the present disclosure have been described in detail, it will be apparent to those skilled in the art that various modifications and variations can be made to the embodiments. However, it is to be understood that such modifications and variations are within the scope and spirit of the present disclosure as described in the appended claims. Furthermore, the present disclosure described herein is susceptible to other embodiments and may be embodied or carried out in various ways.

## Claims

1. A wafer processing device comprising a driving unit, a transfer chamber, a plurality of process chambers, a first air extraction device, a second air extraction device, and a bearing assembly; and
the process chambers coupled to the transfer chamber; wherein the transfer chamber is configured to provide a sealed space, the first air extraction device is coupled to the transfer chamber, and the first air extraction device is configured to extract gas in the transfer chamber to carry out a first vacuum treatment on the transfer chamber; wherein the process chambers are configured for processing wafers, the second air extraction device or devices are coupled to the process chambers, and the second air extraction device is configured to extract gas in the process chamber to carry out a second vacuum treatment on the process chamber; the bearing assembly is arranged in the transfer chamber, the bearing assembly is configured for supporting the wafers; and the driving unit is configured to adjust a position of the bearing assembly in the transfer chamber, and further to drive the bearing assembly to move between the transfer chamber and the process chambers.

2. The wafer processing device according to claim 1, wherein the process chambers are defined to have a first pre-heating chamber and a first mini processing chamber, the first pre-heating chamber configured to pre-heat the wafers and the first mini processing chamber configured to process the pre-heated wafers.

3. The wafer processing device according to claim 2, wherein the process chambers are defined to have a first pre-heating chamber, a second pre-heating chamber, a first mini processing chamber and a second mini processing chamber, wherein the first pre-heating chamber and the second pre-heating chamber are configured to pre-heat or heat a first group of wafers and a second group of wafers respectively, and the first mini processing chamber and the second mini processing chamber are configured to process the first group of pre-heated or heated wafers and the second group of pre-heated or heated wafers.

4. The wafer processing device according to claim 1, wherein the process chambers are provided on an upper side or a lower side of the transfer chamber, and the driving unit is provided on a side of the transfer chamber away from the process chamber.

5. The wafer processing device according to claim 1, wherein the driving unit comprises a first driving mechanism, a second driving mechanism and a transfer;
wherein the transfer is arranged in the transfer chamber, the first driving mechanism is coupled to the transfer, and the first driving mechanism is configured for driving the transfer to move or rotate at an angle; and
wherein the bearing assembly is arranged on the transfer, the second driving mechanism is arranged on a side of the transfer, and the second driving mechanism is configured for driving the bearing assembly to move between the process chamber and the transfer chamber.

6. The wafer processing device according to claim 5, wherein the transfer and the first driving mechanism are detachably coupled thereto.

7. The wafer processing device according to claim 6, wherein the driving unit further comprises a third driving mechanism; and
wherein the third driving mechanism is arranged on a side of the transfer, and the third driving mechanism is configured for driving the transfer and the bearing assembly to move.

8. The wafer processing device according to claim 5, wherein there are provided with at least two bearing assemblies.

9. The wafer processing device according to claim 5, wherein at least two second driving mechanisms are provided, and each of the second driving mechanisms works independently.

10. The wafer processing device according to claim 1, wherein the bearing assembly is provided with N support portions, each of the support portions is configured for supporting the wafer, and N is an integer greater than 1.

11. The wafer processing device according to claim 1, wherein there are provided with a plurality of process chambers, each of the process chambers works independently, and the driving unit is configured for driving the bearing assembly to move between the plurality of process chambers and the transfer chamber.

12. The wafer processing device according to claim 1, further comprising a feeding mechanism;
wherein the feeding mechanism is coupled to the process chamber, and the feeding mechanism is configured for providing raw materials for the process chamber to process the wafer.

13. The wafer processing device according to claim 1, further comprising a seal or assembly provided on the bearing assembly, the seal or assembly being configured to separate the transfer chamber from the process chamber.

14. The wafer processing device according to claim 1, further comprising a fourth driving mechanism; and
the fourth driving mechanism is arranged on a side of the bearing assembly, and the fourth driving mechanism is configured for driving the bearing assembly to rotate at an angle.

15. The wafer processing device according to claim 1, further comprising an equipment body;
wherein the equipment body is provided with the process chamber and the transfer chamber, the driving unit is arranged on the equipment body, and a sealing mode between the driving unit and the equipment body is adopted with a dynamic seal.

16. The wafer processing device according to claim 15, further comprising a fifth driving mechanism;
wherein the equipment body comprises a first fixing part and a second fixing part;
wherein the process chamber is arranged on the first fixing part, and the first fixing part and the second fixing part are stacked with each other to form the transfer chamber within the first fixing part and the second fixing part; and
wherein the fifth driving mechanism is arranged on the first fixing part and/or the second fixing part, and the fifth driving mechanism is configured to drive the first fixing part or the second fixing part to move.

17. The wafer processing device according to claim 1, further comprising a heating unit; wherein the heating unit is coupled to the transfer chamber, and the heating unit is configured for heating the transfer chamber.

18. A wafer processing system, comprising a transport device and a wafer processing device according to any one of claims 1 to 19;
wherein the wafer processing device is provided with a transport channel, a transport device is coupled to the transport channel, and the transport device is configured for transporting the wafer.

19. The wafer processing system according to claim 18, wherein at least two wafer processing devices are provided, and the two wafer processing devices are provided on different sides of the transport device, the transport device is configured for transporting the wafers to the respective wafer processing devices, and the transport device is configured for transporting the wafers of the respective wafer processing devices.

20. The wafer processing system according to claim 18, further comprising a front processing device;
wherein the front processing device is arranged at a side of the transport device, the front processing device is provided with a wafer circulating box, the transport device is configured to transport the wafer to the wafer circulating box and/or the wafer processing device, and the front processing device is configured for transporting the wafer circulating box.

21. The wafer processing system according to claim 20, further comprising a wafer transport box and a transport mechanism;
wherein the wafer transport box is arranged on the front processing device, and the front processing device is configured for conveying the wafer circulating box to the wafer transport box; and
the transport mechanism is configured for conveying the wafer transport box.

22. A control method of the wafer processing device according to claim 1, comprising:
S 1. transmitting a wafer to a bearing assembly in a transfer chamber, wherein a first air extraction device is coupled to the transfer chamber, and the first air extraction device is configured to extract gas in the transfer chamber to carry out a first vacuum treatment on the transfer chamber;
S2. driving the bearing assembly to move to a process chamber by a driving unit,, wherein a second air extraction device is coupled to the process chamber, and the second air extraction device is configured to extract gas in the process chamber to carry out a second vacuum treatment on the process chamber;
S3. processing the wafer on the bearing assembly by the process chamber;
S4. driving the bearing assembly to transport a processed wafer to the transfer chamber by driving unit; and
S5. removing the processed wafer from the transfer chamber.

23. The control method of the wafer processing device according to claim 22, wherein the driving unit comprises a first driving mechanism, a second driving mechanism, and a transfer;
the step S2 specifically comprises:
S21. driving the bearing assembly on the transfer to move by the first driving mechanism so as to adjust a position of the bearing assembly in the transfer chamber; and
S22. driving the bearing assembly to move to the process chamber by the second driving mechanism.

24. The control method of the wafer processing device according to claim 23, wherein the process chamber is provided on an upper face or a lower face of the transfer chamber, and the driving unit is provided on a side of the transfer chamber away from the process chamber; and
the step S22 specifically comprises: driving the bearing assembly to move to the process chamber by the second driving mechanism along an upwardly or downwardly direction.

25. The control method of the wafer processing device according to claim 24, wherein at least two second driving mechanisms are provided, and each of the two second driving mechanisms works independently; and
the step S22 further comprises: driving the bearing assembly to move to the process chamber by the at least two second driving mechanisms, in an up or down direction.

26. The control method of the wafer processing device according to claim 22, wherein there are provided with a plurality of the process chambers, each of the plurality of process chambers works independently, and the plurality of the process chambers comprise a first pre-heating chamber and a first mini processing chamber;
the step S2 and the step S3 specifically comprise:
S31. driving the bearing assembly to move to the first pre-heating chamber by the driving unit to pre-heat or heat the wafers on the bearing assembly; and
S32. driving the bearing assembly to move to the first mini processing chamber by the driving unit to process the pre-heated or heated wafers on the bearing assembly.

27. The control method of the wafer processing device according to claim 26, wherein there are two pre-heating chambers and two mini processing chambers;
the step S31 specifically comprises:
S311. driving the bearing assembly to enable a first group of wafers to be moved to a first pre-heating chamber by the driving unit to pre-heat or heat the first group of wafers on the bearing assembly for a first predetermined time; and
S312. driving the bearing assembly to enable a second group of wafers to be moved to a second pre-heating chamber by the driving unit to pre-heat or heat the second group of wafers on the bearing assembly for a second predetermined time;
the step S32 specifically comprises:
S321. driving the bearing assembly to enable the first group of preheated or heated wafers to be moved to a first mini processing chamber by the driving unit so as to carry out a first process treatment on the wafers on the bearing assembly; and
S322. driving the bearing assembly to enable the second group of preheated or heated wafers to be moved to a second mini processing chamber by the driving unit so as to carry out a second process treatment on the wafers on the bearing assembly.

28. The control method of the wafer processing device according to claim 22, wherein there are provided with two bearing assemblies, two pre-heating chambers and two mini processing chambers;
the step S31 specifically comprises: driving the two bearing assemblies to enable the first group of wafers and the second group of wafers to be moved to the two pre-heating chambers respectively by the driving unit, and pre-heating or heating the first group of wafers and the second group of wafers on the two bearing assemblies in a first pre-heating chamber and a second pre-heating chamber respectively within the first predetermined time; and
the step S32 specifically comprises: driving the two bearing assemblies to enable the first group of pre-heated or heated wafers and the second group of pre-heated or heated wafers to be moved to the two mini processing chambers respectively by the driving unit, and processing the first group of pre-heated or heated wafers and the second group of pre-heated or heated wafers on the two bearing assemblies in a first mini processing chamber and a second mini processing chamber respectively at least within the second predetermined time.

29. The control method of the wafer processing device according to claim 22, further comprising:
S0. providing a front processing device and a transport device; and
the step S1 specifically comprises: storing the wafers to be processed in the front processing device, and enabling the wafers to be processed to be moved to the bearing assembly of the transfer chamber by the transport device.
